# EUROPEAN PATENT SPECIFICATION

(11) **EP 1 684 352 B1**
(45) Date of publication and mention of the grant of the patent: **17.09.2008**
(21) Application number: 05425024.6
(22) Date of filing: 21.01.2005
(51) Int. Cl.: H01L 27/24

(54) **Phase-change memory device and manufacturing process thereof**
Phasenwechselspeicher-Vorrichtung und Verfahren zu ihrer Herstellung
Dispositif de mémoire à changement de phase et son procédé de fabrication

(43) Date of publication of application: 26.07.2006
(73) Proprietor: STMicroelectronics S.r.l., 20041 Agrate Brianza (Milano) (IT)
(72) Inventor: Zuliani, Paola, 20146 Milano (IT); Pellizzer, Fabio, 31051 Follina (IT); Bez, Roberto, 20146 Milano (IT)
(74) Representative: Cerbaro, Elena

(56) References cited:
- US-A- 4 725 877
- US-A1- 2004 042 298
- US-A1- 2004 166 604
- US-A1- 2004 202 017
- US-A1- 2004 245 554

## Description

The present invention relates to a phase-change memory (PCM) device and the manufacturing process thereof.

As is known, phase-change memory devices are based upon storage elements which use a class of materials that have the property of switching between two phases having distinct electrical characteristics, associated to two different crystallographic structures of the material forming the storage element, namely a disorderly amorphous phase and an orderly crystalline or polycrystalline phase.

Currently, the alloys of the elements of group VI of the periodic table, such as Te or Se, referred to as calcogenides or calcogenic materials, may be advantageously used in phase-change memory cells. The currently most promising calcogenide is formed by an alloy of Ge, Sb, and Te (Ge₂Sb₂Te₅), which is now widely used for storing information in over-writeable disks.

In the calcogenides, the resistivity varies by two or more orders of magnitude when the material passes from the amorphous phase (which is more resistive) to the crystalline one (which is more conductive), and vice versa.

The phase change can be obtained by increasing the temperature locally. Below 150°C, both the phases are stable. Above 200°C, starting from the amorphous phase, there is a rapid nucleation of the crystallites and, if the material is kept at the crystallization temperature for a sufficient time, it changes phase and becomes crystalline. To bring the calcogenide back into the amorphous state, it is necessary to raise the temperature above the melting point (approximately 600°C) and then cool the calcogenide rapidly.

From the electrical standpoint, it is possible to reach the crystallization and melting temperatures by causing a current to flow through a resistive element (also referred to as a heater), which heats the calcogenic material by the Joule effect.

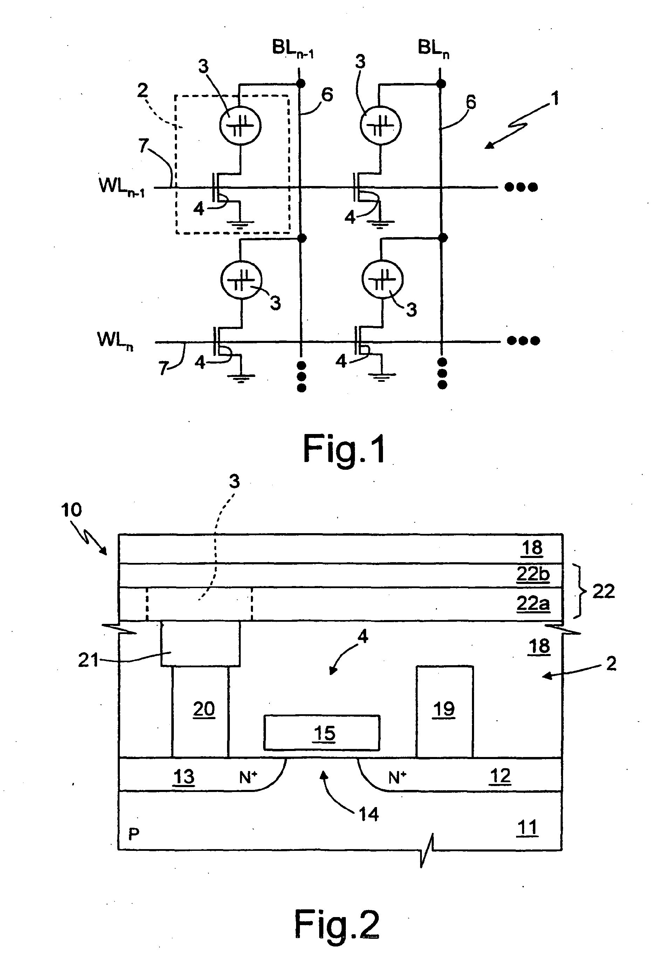

The structure of a phase-change memory array, which uses a calcogenic element as the storage element, is illustrated in Figure 1. The memory array 1 of Figure 1 comprises a plurality of memory cells 2, each including a storage element 3 of a phase-change type and a selection element 4 formed here by an NMOS transistor. Alternatively, the selection element 4 can be formed by a bipolar-junction transistor, by a PN diode or by a calcogenic switch ("ovonic threshold switch").

The invention relates to a memory array wherein the selection element 4 is made as an MOS transistor, to which reference will then be made hereinafter.

The memory cells 2 are arranged in rows and columns. In each memory cell 2, the storage element 3 has a first terminal connected to an own bitline 6 (address bitlines BLn-1, BLn, ...), and a second terminal connected to a first conduction terminal of an own selection element 4. The selection element 4 has a control terminal connected to an own control line, also referred to as a wordline 7 (address wordlines WLn-1, WLn, ...) and a grounded second conduction terminal.

The storage element 3 is formed by a portion of a region of calcogenic material (which forms the proper memory portion) and by a heating element that enables the phase change.

Figure 2 shows the cross-section through a wafer of conductive material wherein a memory cell 2 has been formed.

In detail, a wafer 10 comprises a substrate 11 of a P type accommodating a source region 12 and a drain region 13 of an N+ type. The source and drain regions 12, 13 are reciprocally spaced by a portion 14 of the substrate, which forms a channel region. A gate region 15 (formed by a wordline 7 of Figure 1) extends on top of the substrate 11, vertically aligned to the channel region 14, but isolated with respect to the substrate 11. The source region 12, the drain region 13 and the gate region 15 form an MOS device forming the selection element 4 of Figure 1.

A dielectric region 18 extends on top of the substrate 11 and accommodates within it, in addition to the gate region 15, a source line 19, a drain contact 20, a heating element 21, and a bitline 22.

The source line 19 is formed by a local interconnection line (LIL), which extends transversely with respect to the drawing plane (parallel to the wordline 7) and connects the source regions 12 of the memory cells 2 arranged on a same row of the memory array 1 of Figure 1. The different source lines 19 of memory cells 2 belonging to a same sector are moreover connected to one another and to ground (as represented in the equivalent electrical circuit of Figure 1). In currently proposed devices, the source line 19 is obtained using a contact technique, forming a via in the bottom portion of the dielectric layer 18 and filling the via with conductive material, for example tungsten, possibly coated with a barrier material, such as Ti/TiN.

Generally, the drain contact 20 is made simultaneously and using the same technique as the source line 19, albeit having a different area, of a square or circular shape, and thus it has the same cross-section as the source line 19 in the cross-sectional view of Figure 2 (in particular, it has the same height) but differs in a section perpendicular thereto.

The heating element 21 is made of a resistive material having thermal stability and good compatibility with CMOS processes and with calcogenic materials. For example, TiSiN, TiAlN or TiSiC can be used, formed as a thin layer that coats the walls of a cavity formed in an intermediate portion of the dielectric layer 18. The cavity is then filled with dielectric material.

The bitline 22 preferably comprises a multilayer including at least one calcogenic layer 22a (for example, of Ge₂Sb₂Te₅) and a metal electrode layer 22b (for example, of AlCu); an adhesive layer may moreover be provided (for example, of Ti or Si) underneath the calcogenic layer 22a and/or a barrier layer may be provided on top of the calcogenic layer 22a.

The heating element 21, the drain contact 20 (and thus the source line 19), and the bitline 22 can be obtained as described in detail, for example, in EP-A-1 318 552 or in EP-A-1 339 110, which refer, however, to the construction of memory cells having a selection element of a bipolar type.

Moreover, a phase changeable memory device, having a plurality of access transistors, is described in US 2004/0042298, US 2004/0245554, US 2004/0202017.

The structure of Figure 2 has the disadvantage that it cannot be implemented with all the currently available processes, in particular when the basic CMOS technology does not enable local interconnections of an LIL type to be made.

The aim of the invention is thus to provide a device and a manufacturing process that can be implemented with any currently used or future, CMOS-compatible technique.

According to the present invention, a phase-change memory device and the manufacturing process thereof are provided, as defined in claims 1 and 6, respectively.

For an understanding of the present invention a preferred embodiment thereof is now described, purely by way of nonlimiting example, with reference to the attached drawings, wherein:
- Figure 1 shows the equivalent electrical circuit of a phase-change memory array;
- Figure 2 shows the implementation of a cell of the memory of Figure 1;
- Figures 3-5 show two cross-sectional views and a top view of an embodiment of a memory cell, as known from the prior art;
- Figures 6 and 7 show a cross-sectional view and a top view of an embodiment of a memory cell, as known from the prior art;
- Figures 8 and 9 show two cross-sectional views of a first embodiment of a memory cell;
- Figure 10 shows a cross-sectional view of a second embodiment of a memory cell; and
- Figure 11 is a block diagram of a system that uses the present storage device.

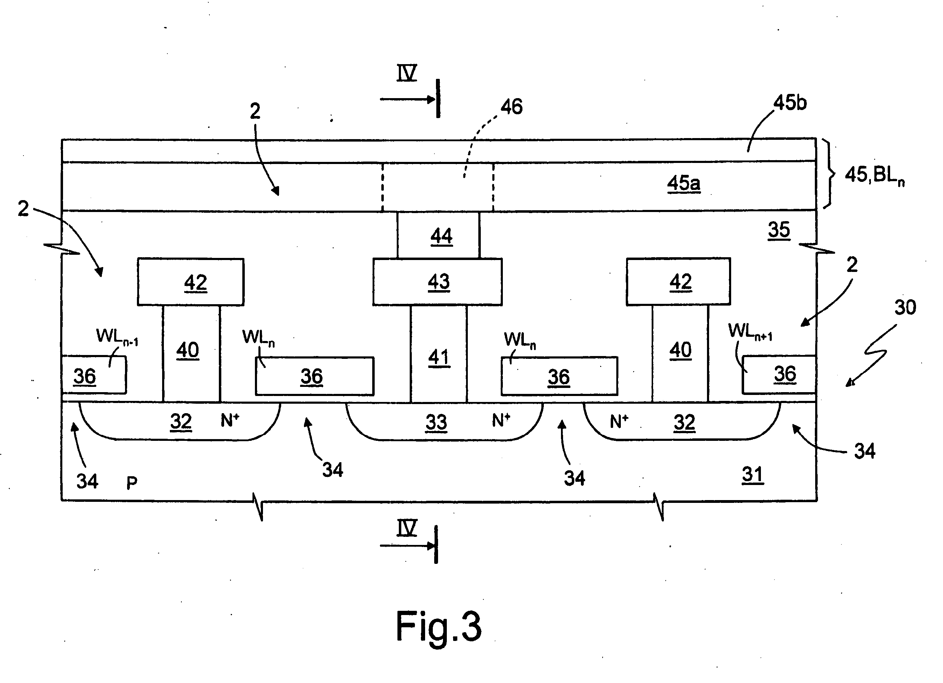

Figures 3-5 belong to an embodiment which is not part of the present invention, wherein the source line is made in a metal layer, and precisely in the first metal level (metal1). Furthermore, the bitline is formed on top of the first metal level, and precisely between the first and second metal levels (not illustrated). Furthermore, the memory cells are split-gate cells, i.e., the selection element 4 is formed by two MOS transistors connected in parallel and thus equivalent to an individual MOS transistor having a width W twice the width of the defined active area.

In detail, a wafer 30 comprises a substrate 31 of a P type accommodating source regions 32 (two of which are visible in Figure 3) and drain regions 33 (just one of which is visible in Figure 3). Between each source region 32 and the adjacent drain region 33, the substrate 31 forms a channel region 34; a dielectric layer 35 coats all the surface of the substrate 31 and accommodates gate regions 36 that extend on the channel regions 34 and are formed by polysilicon lines WL forming the wordlines 7 of Figure 1.

Source-contact regions 40 extend through the dielectric layer 35 between the source regions 32 and the source lines 42; likewise, drain-contact regions or memory-contact regions 41 extend between the drain regions 33 and the metal pad regions 43.

The source-contact regions 40 and drain-contact regions 41 are made in vias opened in the bottom portion of the dielectric layer 35 and are obtained using the contact technique, for example, with tungsten coated with a Ti/TiN barrier layer.

In practice, each source-contact region 40 defines a local contact with a respective source region 32, and the connection between the various source regions 32 is ensured by the source lines 42, which extend at a certain height on top of the substrate and are distinct from the source-contact regions 40 themselves.

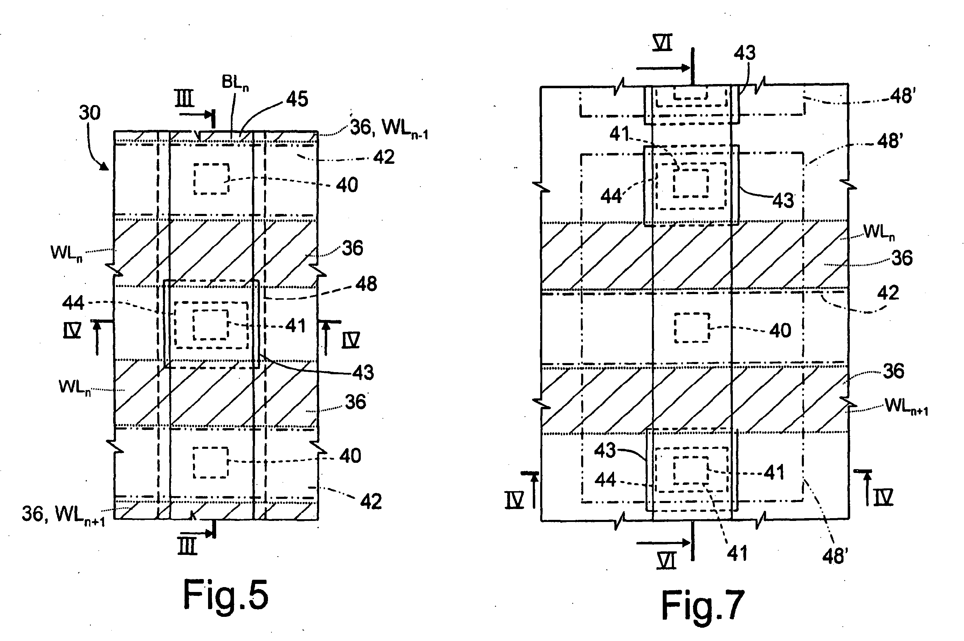

The source lines 42 and the metal pad regions 43 are formed in the first metal level (metal1) which is for example of AlCu or Cu, and have the shape shown in the top view of Figure 5; in particular, the source lines 42 extend parallel to the wordlines WL, while the metal pad regions 43 have a rectangular or square shape.

Heater elements 44, of resistive material, extend on top of the metal pad regions 43. Finally, bitlines 45 are formed on top of the heater elements 44, locally in contact with the heater elements 44.

The bitlines 45 are formed by a bottom layer 45a, of calcogenic material, and by a top layer 45b, of metal material, for example AlCu or Cu.

In practice, Figures 3 and 5 show in a complete way just one memory cell 2, comprising a column 41, 43, 44, a drain region 33, two gate regions 36 (wordlines WLₙ), and two source regions 32; the source regions 32 are moreover shared with the adjacent memory cells 2, connected to the wordlines WLₙ₋₁ and WLₙ₊₁.

It is emphasized that Figures 3-5 are only schematic as regards the heater elements 44 and the bitlines 45, and these could be modified as described in the European patents cited above so as to obtain sublithographic contact regions. For example, each heating element 44 could be formed by a wall of material deposited in an appropriate cavity, and the bitlines 45 could comprise further layers, such as an adhesion layer and/or a barrier layer and could be shaped so as to have a thinner bottom portion. For example, the bottom layer 45a could be formed by a thin line that crosses the walls forming the heater elements. Alternatively, should considerations of a thermal type not require the presence of submicrometric contact regions between the heating material and the calcogenic material, the structure of the heater elements 44 and of the bitlines 45 could correspond to the one illustrated in the drawings.

In any case, the portions of the bottom layer 45a of the bitlines 45 in contact with the heater elements 44 form storage regions, designated as a whole by 46, the phase whereof (whether crystalline or amorphous) represents the information stored.

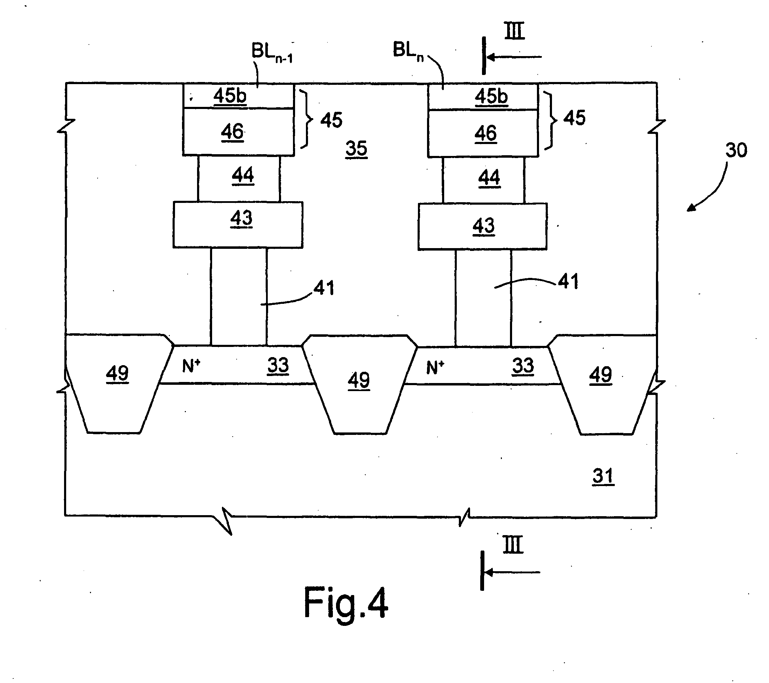

For completeness, it is pointed out that, in the top view of Figure 5, the line 48 represents the active-area mask which, in this embodiment, is strip-shaped and extends through the entire column. Furthermore, field-isolation regions 49 are visible in the cross-section of Figure 4 (preferably formed through shallow-trench isolation - STI), and separate cells 2 that are adjacent in the direction of the wordlines WL (and thus of the source lines 42).

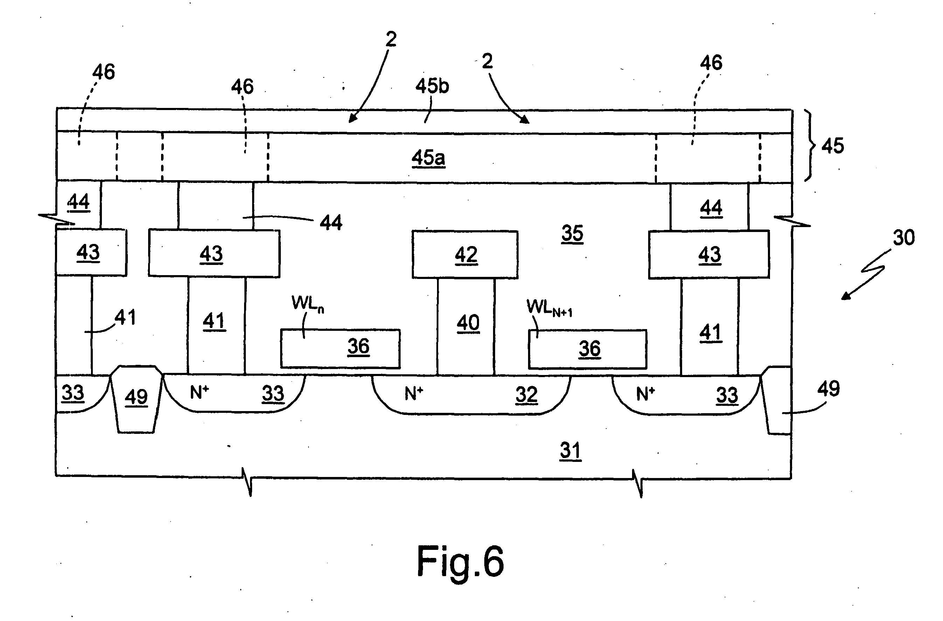

Figures 6 and 7 refer to a different embodiment that does not belong to the present invention, referred to as split-active, wherein the active areas 48' are formed by rectangles of width W, corresponding to two adjacent memory cells 2. In practice, here, each active area accommodates two drain regions 33 and a single source region 32, which is intermediate and is shared by the two memory cells 2. In this case, the cross-section perpendicular to that of Figure 6 coincides with that of Figure 4.

The embodiments of Figures 3-5 and 6-7 are both characterized in that the definition of the storage element 46 occurs after definition of the metal1 level, and the heater elements 44 are defined between the metal1 level and the bitlines 45. This approach has the main advantage of reducing the thermal budget seen by the bottom layer 45a, of calcogenic material, of the bitlines 45, maintaining the same basic architecture of traditional memory cells 2, and thus without having to modify excessively the existing design criteria.

Furthermore, with the presented solutions it is possible to save a mask (LIL or pre-contact mask), if this is not required by the basic CMOS process.

In these two cases, the second metal level (meta12, not illustrated) can be advantageously used for strapping of the wordlines WL, in a per se known manner. The use of the first solution or of the second solution depends upon the technology adopted (layout rules) and upon the sizing of the MOS transistor (width W and length L of the gate); in practice, the two solutions provide different shape factors (i.e., the ratio between global width and length of each cell), and during the design phase it is possible to use the optimal solution for the required specifications.

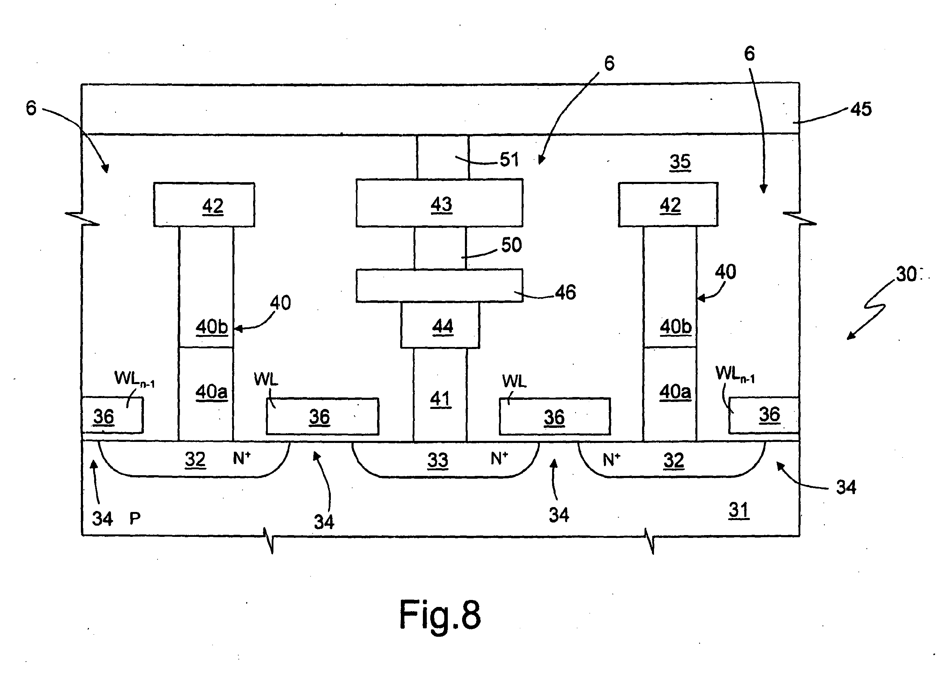

Figures 8-10 show a first embodiment of the invention, wherein the storage region 46 is not formed by the bitline 45 but by an appropriate region (rectangular dot or pad) set underneath the metal1 level. Furthermore, the first embodiment implements a solution of the split-gate type, like the embodiment of Figs. 3-5. The first embodiment has a similar top view as the embodiment of Figure 5, except, as mentioned, for the shape of the regions of calcogenic material, consequently the top view is not illustrated.

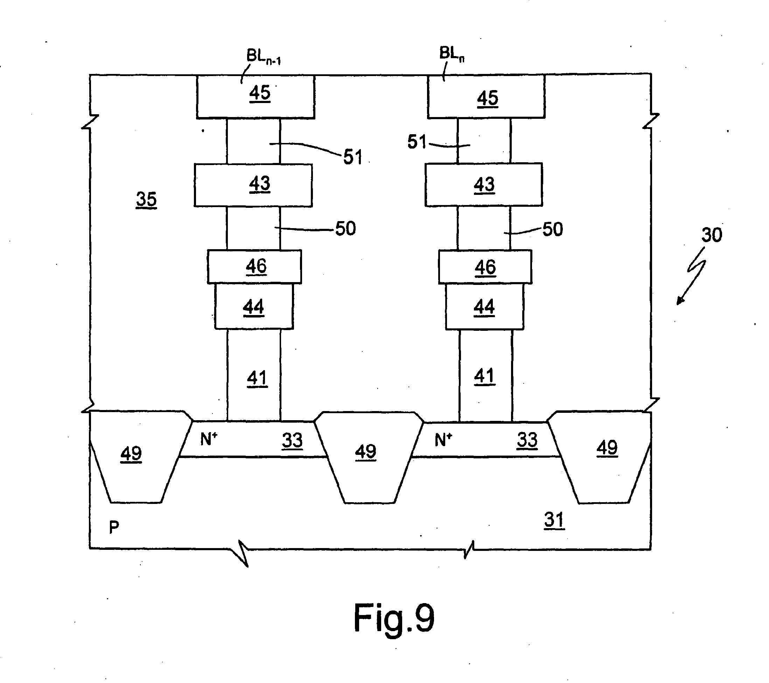

In detail, in Figures 8 and 9, the source-contact regions 40 are formed by different parts and comprise a bottom portion 40a, equivalent to the contact region 40 of Figures 3-7, and a top portion 40b, formed using the same technique and aligned to the bottom portion 40a, thereby, globally, the source-contact regions 40 of Figures 8 and 9 have a height greater than the height of those of Figures 3-7.

Furthermore, the heater elements 44 are formed immediately on top of the drain-contact or memory regions 41; the storage regions 46 (of calcogenic material) are arranged immediately on top of the heater elements 44; and first contact portions 50 are formed on top of the storage regions 46 and extend up to the level of the metal1 level. Metal pad regions 43 are here formed on top of the first contact portions 50, at the same height as the source lines 42, since both the source lines 42 and the metal pad regions 43 are formed in the first metal level (metal1).

On top of the metal pad regions 43, second contact portions 51 are present, which connect the metal pad regions 43 and thus the storage regions 46 to the bitlines 45, which are here formed by the second metal level (metal2) and are obtained with the techniques normally used for metal interconnections (for example, AlCu or Cu interconnections).

In practice, since the storage regions 46 are here made separately from the bitlines 45, underneath the metal1 level, the source-contact regions 40 are made by two different portions 40a, 40b, arranged on top of one another and made at two different times, the first portions 40a using the contact technique, before the formation of the heater elements 44, and the second portions 40b using the same contact technique, after the formation of the storage regions 46, and the deposition and planarization of an intermediate portion of the dielectric layer 35, together with the first contact portions 50. After formation of the source lines 42, of the metal pad regions 43, and possibly of other regions in the first metal level (metal1), deposition and planarization of a further portion of the dielectric layer 35, and formation of the second contact portions 51 (also these formed using the contact technique), the bitlines 45 are formed.

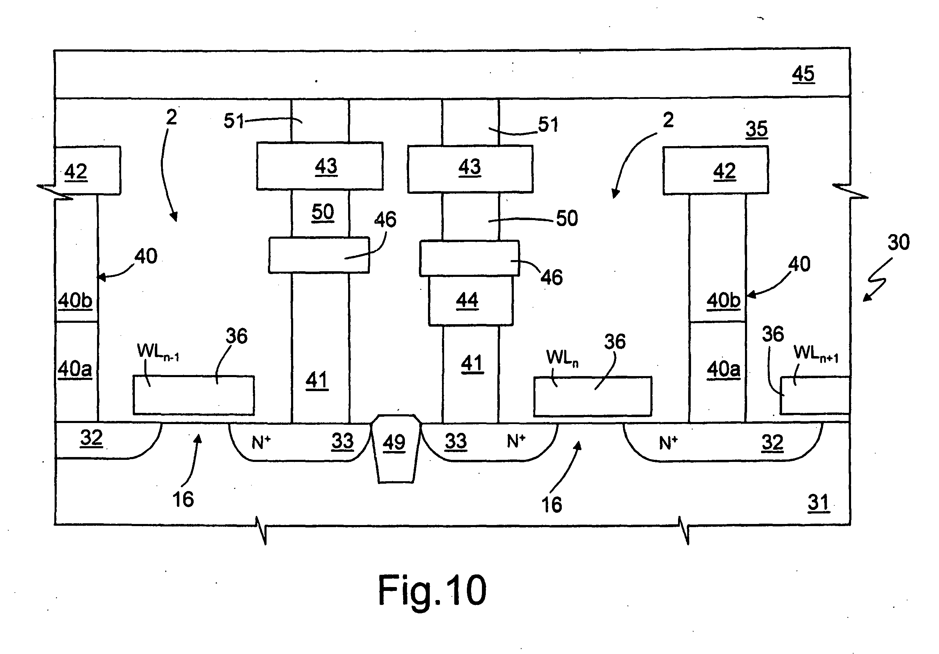

Figure 10 shows a second embodiment differring from the first embodiment of Figures 8-9, of the split-active type wherein, similarly to the embodiment of Figures 6 and 7, the active-area mask has separate windows for each memory cell 2. In this second embodiment, the cross-section perpendicular to Figure 10 is the same as in Figure 9 and the top view is similar to Figure 7 (apart from the shape of the region of calcogenic material), and consequently said views are not shown.

The first and second embodiments illustrated in Figures 8-10 have the advantage that the storage regions 46 are separated from the bitlines 45 and can be located only where necessary. In this way, it is possible to avoid some process steps (such as deposition and definition of the top metal layer 45b, on top of the calcogenic material 45a), which are, instead, necessary for the embodiments shown in Figures 3-7 for reducing the resistivity of the bitlines 45.

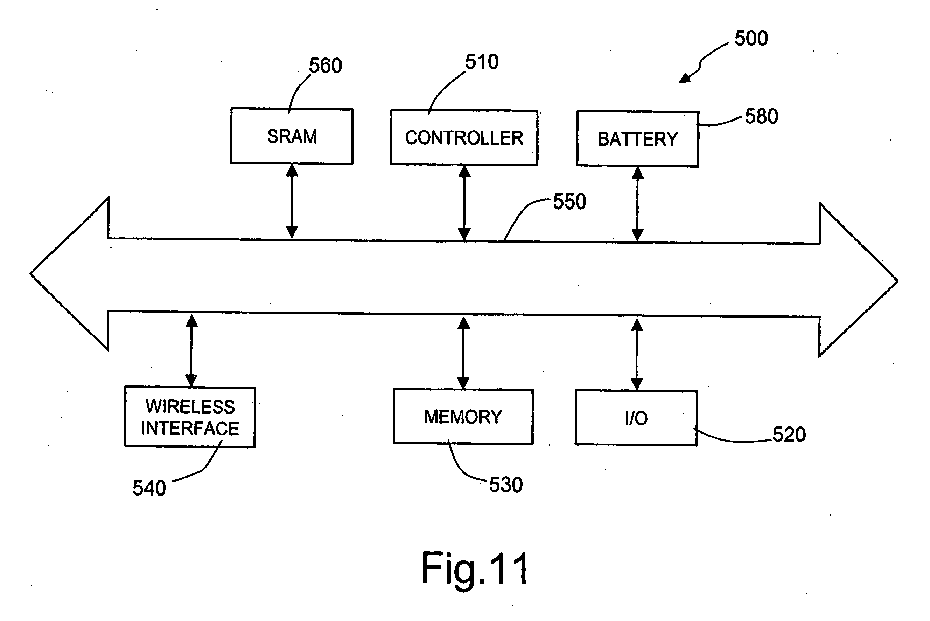

Figure 11 shows a portion of a system 500 according to a third embodiment of the present invention. The system 500 can be used in wireless devices such as, for example, a personal digital assistant (PDA), a laptop or portable computer with wireless capacity, a "web tablet", a wireless telephone, a pager, a device for sending instantaneous messages, a digital music player, a digital camcorder, or other devices that can be suitable for transmitting and/or receiving information in wireless mode. The system 500 can be used in any one of the following systems: a wireless local area network (WLAN) system, a wireless personal area network (WPAN) system, or a cellphone network, even though the extent of the present invention is not limited in this connection.

The system 500 comprises a controller 510, an I/O device 520 (for example, a keyboard or a display), a memory 530, a wireless interface 540, and a static random-access memory (SRAM) 560, connected to one another through a bus 550. A battery 580 supplies the system 500.

The controller 510 comprises, for example, one or more microprocessors, digital signal processors, microcontrollers, or the like. The memory 530 can be used for storing messages transmitted to or received by a system 500. The memory 530 can optionally be used also for storing instructions that are executed by the controller 510 during operation of the system 500, and can be used for storing user data. The instructions can be stored as digital information, and the user data, as described herein, can be stored in one section of the memory as digital data and, in another section, as analog memory. In another example, one data section at a time can be labeled as such and can store digital information, and can then be re-labeled and reconfigured for storing analog information. The memory 530 can be provided with one or more types of memory. However, in the third embodiment of the present invention, the memory 530 comprises a memory that includes the memory array 1 of Figure 1 including a memory cell as shown in Figures 8-10.

The I/O device 520 can be used for generating a message. The system 500 can use the wireless interface 540 for transmitting and receiving messages to and from a wireless communication network with a radio-frequency (RF) signal. Examples of wireless interfaces 540 comprise an antenna or a wireless transceiver, such as a dipole antenna, even though the scope of the present invention is not limited in this respect. Furthermore, the I/O device 520 can provide a voltage reflecting what is stored as either a digital output (if digital information was stored), or as analog information (if analog information was stored).

## Claims

1. A phase-change memory device, comprising an array (1) of memory cells (2) arranged in rows (7) and columns (6) and each including a selection device (4) of an MOS type and a phase-change region (3) connected to said selection device, said selection device (4) having a first conductive region (32) and a second conductive region (33), formed in a substrate (31) of semiconductor material and spaced from one another by a channel region (34), and an isolated control region (36) connected to a respective one of said rows (7) of said array and overlying said channel region (34); said first conductive region (32) being connected to a connection line (42) via a source-contact region (40), said connection line extending parallel to said rows and being a metal interconnection line formed in a first metal level, said second conductive region (33) being connected to said phase-change region (46) which is connected to a respective one of said columns (6) of said array, in each cell, said source-contact region (40) defining a local contact between a respective first conductive region (32) and said connection line (42), with said connection line connecting, to each other, the first conductive regions (32) of different memory cells (2), **characterized in that**
said phase-change region (46) extends at lower height than said first metal level and said connection line (42).

2. The device according to claim 1, wherein said second conductive region (33) is connected to said phase-change region (46) through a memory-contact region (41), and said phase-change region (46) forms a dot and is connected to said column (45) through at least one first contact portion (50).

3. The device according to claim 2, comprising a metal-pad region (43) formed in said first metal level and aligned horizontally with said metal interconnection line (42), said metal-pad region (43) being connected to said phase-change region (46) through said first contact portion (50) and to said column (45) through a second contact portion (51).

4. The device according to claim 3, comprising a heating element (44) extending between said phase-change region (46) and said memory-contact region (41).

5. The device according to any one of claims 2-4, wherein said column (45) is formed by a line of metal material formed in a second metal level and extends on top of said phase-change region (46) and said metal interconnection line (42).

6. A manufacturing process of a phase-change memory device (530), comprising an array (1) of memory cells (2) arranged in rows (7) and columns (6) and each including a selection device (4) of an MOS type and a phase-change region (3) connected to said selection device, the process comprising the steps of:
forming a first conductive region (32) and a second conductive region (33) in a substrate (31) of semiconductor material, said first and second conductive regions being spaced from one another by a channel region (34);
forming a wordline (7) defining an isolated control region (36), which extends on top of said channel region (14) parallel to said rows (7);
forming a memory-contact region (41) on top of and electrically connected to said second conductive region (33);
forming a phase-change region (46) on top of and electrically connected to said memory-contact region (41);
forming a source-contact region (40) on top of and in contact with a respective said first conductive region (32) simultaneously with said memory-contact region (41)
subsequently forming a metal interconnection line (42) in a first metal level, on top of and electrically connected to said first conductive region (32) and said source-contact region (40), said connection line (42) extending parallel to said wordline (7) and connecting, to each other, the first conductive regions (32) of different memory cells (2);
**characterized in that** said metal interconnection line (42) is formed at a greater height than said phase-change region (46).

7. A system (500) comprising:
a processing unit (510);
an interface (540) coupled to said processing unit (510); and
a phase-change memory device (530) according to claim 1 or 2, coupled to said processing unit (510).

## Patentansprüche

1. Phasenänderungsspeichervorrichtung, ausweisen eine Anordnung (1) von Speicherzellen (2), die in Zeilen (7) und Spalten (6) angeordnet sind und jeweils eine Auswahlvorrichtung (4) eines MOS-Typs und einen Phasenänderungsbereich (3), der mit der Auswahlvorrichtung gekoppelt ist, aufweisen, wobei die Auswahlvorrichtung (4) einen ersten leitenden Bereich (32) und einen zweiten leitenden Bereich (33), die in einem Substrat (31) aus Halbleitermaterial gebildet sind und voneinander mittels eines Kanalbereichs (34) räumlich getrennt sind, und einen isolierten Steuerbereich (36) aufweist, der mit einer jeweiligen Zeile der Zeilen (7) der Anordnung gekoppelt ist und über dem Kanalbereich (34) liegt;
wobei der erste leitende Bereich (32) mit einer Verbindungsleitung (42) mittels eines Source-Kontakt-Bereichs (40) gekoppelt ist, wobei die Verbindungsleitung sich parallel zu den Zeilen erstreckt und eine Metall-Kopplungsleitung ist, die in einer ersten Metallebene gebildet ist,
wobei der zweite leitende Bereich (33) mit dem Phasenänderungsbereich (46), der mit einer jeweiligen Spalte der Spalten (6) der Anordnung gekoppelt ist, gekoppelt ist,
wobei in jeder Zelle der Source-Kontakt-Bereich (40) einen lokalen Kontakt zwischen einem jeweiligen ersten leitenden Bereich (32) und der Verbindungsleitung (42) definiert, wobei die Verbindungsleitung die ersten leitenden Bereiche (32) unterschiedlicher Speicherzellen (2) miteinander koppelt, **dadurch charakterisiert, dass**
der Phasenänderungsbereich (46) sich in geringerer Höhe als die erste Metallebene und die Verbindungsleitung (42) erstreckt.

2. Vorrichtung gemäß Anspruch 3, wobei der zweite leitende Bereich (33) mit dem Phasenänderungsbereich (46) durch einen Speicherkontaktbereich (41) gekoppelt ist und der Phasenänderungsbereich (46) einen Punkt bildet und mit der Spalte (45) durch mindestens einen ersten Kontaktteilbereich (59) gekoppelt ist.

3. Vorrichtung gemäß Anspruch 2, aufweisend einen Metallfeld-Bereich (43), der in der ersten Metallebene gebildet ist und horizontal mit der Metall-Kopplungsleitung (42) aufgerichtet ist, wobei der Metallfeld-Bereich (43) mit dem Phasenänderungsbereich (46) durch den ersten Kontaktteilbereich (50) und mit der Spalte (45) durch einen zweiten Kontaktteilbereich (51) gekoppelt ist.

4. Vorrichtung gemäß Anspruch 3, aufweisend ein Heizelement (44), das sich zwischen dem Phasenänderungsbereich (46) und dem Speicherkontaktbereich (41) erstreckt.

5. Vorrichtung gemäß irgendeinem der Ansprüche 2 bis 4, wobei die Spalte (45) durch eine Leitung aus Metall-Material, die in einer zweiten Metallebene gebildet ist, gebildet wird und sich oben auf dem Phasenänderungsbereich (46) und der Metall-Kopplungsleitung (42) erstreckt.

6. Herstellungsverfahren für eine Phasenändernngsspeichervorrichtung (530), aufweisend eine Anordnung (1) von Speicherzellen (2), die in Zeilen (7) und Spalten (6) angeordnet sind und jeweils eine Auswahlvorrichtung (4) eines MOS-Typs und einen Phasenänderungsbereich (3), der mit der Auswahlvorrichtung gekoppelt ist, aufweisen, wobei das Verfahren die Schritte aufweist:
Bilden eines ersten leitenden Bereichs (32) und eines zweiten leitenden Bereichs (33) in einem Substrat (31) aus Halbleitermaterial, wobei der erste leitende Bereich und der zweite leitende Bereich voneinander mittels eines Kanalbereichs (34) räumlich getrennt sind;
Bilden einer Wortleitung (7), die einen isolierten Steuerbereich (36) definiert, der sich oben auf dem Kanalbereich (14) parallel zu den Zeilen (7) erstreckt;
Bilden eines Speicherkontaktbereichs (41) oben auf und elektrisch gekoppelt mit dem zweiten leitenden Bereich (33);
Bilden eines Phasenänderungsbereichs (46) oben auf und elektrisch gekoppelt mit dem Speicherkontaktbereich (41);
Bilden eines Source-Kontakt-Bereichs (40) oben auf und in Kontakt mit einem jeweiligen ersten leitenden Bereich (32) gleichzeitig mit dem Speicherkontaktbereich (41) anschließendes Bilden einer Metall-Kopplungsleitung (42) in einer ersten Metallebene oben auf und elektrisch gekoppelt mit dem ersten leitenden Bereich (32) und dem Source-Kontakt-Bereich (40), wobei die Kopplungsleitung (42) sich parallel zu der Wortleitung (7) erstreckt und
Koppeln des ersten leitenden Bereichs (32) unterschiedlicher Speicherzelle (2) miteinander; **dadurch charakterisiert, dass** die Metall-Verbindungsleiwng (42) in einer größeren Höhe gebildet ist als der Phasenänderungsbereich (46).

7. System (500), aufweisend;
eine Verarbeitungseinheit (510);
eine Schnittstelle (540), die mit der Verarbeitungseinheit (510) gekoppelt ist; und
eine Phasenänderungsspeirhervorrichtung (530) gemäß Anspruch 1 oder 2, die mit der Verarbeitungseinheit (510) gekoppelt ist.

## Revendications

1. Dispositif de mémoire à changement de phase, comprenant un ensemble (1) de cellules de mémoire (2) disposées en lignes (7) et en colonnes (6) et chacune comprenant un dispositif de sélection (4) d'un type MOS et une zone à changement de phase (3) connectée audit dispositif de sélection, ledit dispositif de sélection (4) comprenant une première zone conductrice (32) et une seconde zone conductrice (33), formées dans un substrat (31) en matériau semi-conducteur et éloignées l'une de l'autre par une zone de canal (34), et une zone de commande isolée (36) connectée à l'une respective desdites lignes (7) dudit ensemble et recouvrant ladite zone de canal (34) ; ladite première zone conductrice (32) étant connectée à une ligne de connexion (42) via une zone de contact de source (40), ladite ligne de connexion s'étendant parallèlement auxdites lignes et étant une ligne d'interconnexion métallique formée dans un premier niveau métallique, ladite seconde zone conductrice (33) étant connectée à ladite zone à changement de phase (46) qui est connectée à l'une respective desdites colonnes (6) dudit ensemble,
dans chaque cellule, ladite zone de contact de source (40) définissant un contact local entre une première zone conductrice (32) respective et ladite ligne de connexion (42), avec ladite ligne de connexion connectant, les unes aux autres, les premières zones conductrices (32) de différentes cellules de mémoire (2),
**caractérisé en ce que** ladite zone à changement de phase (46) s'étend à une hauteur inférieure à celle dudit premier niveau métallique et de ladite ligne de connexion (42).

2. Dispositif selon la revendication 1, dans lequel ladite seconde zone conductrice (33) est connectée à ladite zone à changement de phase (46) par le biais d'une zone de contact de mémoire (41), et ladite zone à changement de phase (46) forme un point et est connectée à ladite colonne (45) par le biais d'au moins une première partie de contact (50).

3. Dispositif selon la revendication 2, comprenant une zone de plot métallique (43) formée dans ledit premier niveau métallique et alignée horizontalement avec ladite ligne d'interconnexion métallique (42), ladite zone de plot métallique (43) étant connectée à ladite zone à changement de phase (46) par le biais de ladite première partie de contact (50) et à ladite colonne (45) par le biais d'une seconde partie de contact (51).

4. Dispositif selon la revendication 3, comprenant un élément de chauffage (44) s'étendant entre ladite zone à changement de phase (46) et ladite zone de contact de mémoire (41).

5. Dispositif selon l'une quelconque des revendications 2 à 4, dans lequel ladite colonne (45) est formée par une ligne de matériau métallique formée dans un second niveau métallique et s'étend au-dessus de ladite zone à changement de phase (46) et de ladite ligne d'interconnexion métallique (42).

6. Procédé de fabrication d'un dispositif de mémoire à changement de phase (530), comprenant un ensemble (1) de cellules de mémoire (2) disposées en lignes (7) et en colonnes (6) et chacune comprenant un dispositif de sélection (4) d'un type MOS et une zone à changement de phase (3) connectée audit dispositif de sélection, le procédé comprenant les étapes consistant à :
former une première zone conductrice (32) et une seconde zone conductrice (33) dans un substrat (31) en matériau semi-conducteur, lesdites première et seconde zones conductrices étant éloignées l'une de l'autre par une zone de canal (34) ;
former une ligne de mots (7) définissant une zone de commande isolée (36) qui s'étend au-dessus de ladite zone de canal (14) parallèle auxdites lignes (7) ;
former une zone de contact de mémoire (41) au-dessus de et connectée électriquement à ladite seconde zone conductrice (33) ;
former une zone à changement de phase (46) au-dessus de et connectée électriquement à ladite zone de contact de mémoire (41) ;
former une zone de contact de source (40) au-dessus de et en contact avec une dite première zone conductrice (32) respective simultanément avec ladite zone de contact de mémoire (41),
former ensuite une ligne d'interconnexion métallique (42) dans un premier niveau métallique, au-dessus de et connectée électriquement à ladite première zone conductrice (32) et à ladite zone de contact de source (40), ladite ligne de connexion (42) s'étendant parallèlement à ladite ligne de mots (7) et connectant, les unes aux autres, les premières zones conductrices (32) de différentes cellules de mémoire (2) ;
**caractérisé en ce que** ladite ligne d'interconnexion métallique (42) est formée à une hauteur supérieure à celle de ladite zone à changement de phase (46).

7. Système (500) comprenant :
une unité de traitement (510) ;
une interface (540) couplée à ladite unité de traitement (510) ; et
un dispositif de mémoire à changement de phase (530) selon la revendication 1 ou 2, couplé à ladite unité de traitement (510).
